(19) Europäisches Patentamt
European Patent Office
Office européen des brevets

(11) **EP 4 269 655 A1**

(12) **EUROPEAN PATENT APPLICATION**

(43) Date of publication:
**01.11.2023 Bulletin 2023/44**

(21) Application number: **22170878.7**

(22) Date of filing: **29.04.2022**

(51) International Patent Classification (IPC):
*C23C 28/04* (2006.01)   *C23C 28/00* (2006.01)
*C23C 30/00* (2006.01)   *C23C 14/02* (2006.01)
*C23C 14/06* (2006.01)   *C23C 14/32* (2006.01)

(52) Cooperative Patent Classification (CPC):
**C23C 28/04; C23C 14/0641; C23C 14/325;
C23C 28/044; C23C 28/048; C23C 28/40;
C23C 28/42; C23C 28/44; C23C 30/005**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **WALTER AG
72072 Tübingen (DE)**

(72) Inventors:
• **LIEBIG, Jan Philipp
Tübingen (DE)**
• **SCHIER, Veit
Tübingen (DE)**

(74) Representative: **Sandvik
Sandvik Intellectual Property AB
811 81 Sandviken (SE)**

(54) **A COATED CUTTING TOOL**

(57)     The present invention relates to a coated cutting tool comprising a substrate and a coating comprising a first, a second and a third layer, wherein

i) the first layer is a (Ti, Al)N layer adhered to the substrate, said first layer having

a. an atomic ratio Al/(Ti+Al) of 0.3 to 0.65

b. a fracture toughness ranging from 3.5 to 6MPa $\sqrt{}$ m

c. a substantially homogeneous residual stress $\sigma_1$ in the range from +100 to -1000 MPa

ii) the second layer is a (Ti, Al)N layer adhered to the first layer having

a. an atomic ratio Al/(Ti+Al) of 0.3 to 0.85

b. a residual stress $\sigma_2$ ranging from about $\sigma_1$ at the interface with the first layer to $\sigma_3$ at the interface with the third layer, wherein $\sigma_2$ gradually increases from the interface with the first layer towards the interface with the third layer adhered to the second layer, wherein the residual stress $\sigma_2$ at the interface with the third layer is substantially the same as in the third layer

iii) the third layer is composed of a nitride of one or more elements belonging to group 4, 5 or 6 of the periodic table of elements, or a nitride of Al and/or Si together with one or more elements belonging to group 4, 5 or 6 of the periodic table of elements, said third layer having a substantially homogenous residual stress $\sigma_3$ < -1200 MPa.

**EP 4 269 655 A1**

**Description**

The invention relates to a coated cutting tool comprising a substrate and a coating comprising a first, a second, and a third layer.

Background

There is a continuous desire to extend the service life of cutting tools for metal machining withstanding higher cutting speeds and/or other increasingly demanding cutting operations. Commonly, a cutting tool for metal machining comprises a hard substrate material such as cemented carbide coated with a thin hard wear resistant coating such as a titanium aluminium nitride (Ti,Al)N coating deposited by means of a PVD method. A single phase cubic crystal structure is generally desired but a threshold with respect to aluminium content to provide such single phase cubic structure rather than a mixed structure comprising both cubic and hexagonal structure exists which may vary to some extent depending on, for example, the deposition conditions. It is further well-known that thicker coatings may impart increased service life up to a certain limit at which high undesired stress concentrations arise in e.g. the coating-to-substrate interface.

It is an objective of the present invention to provide a coated cutting tool having a (Ti, Al)N coating with a single phase cubic structure having high fracture toughness and low residual compressive stress while imparting improved coating-to-substrate adhesion.

A further objective of the present invention is to provide a coated cutting tool with excellent flank wear resistance. A further objective is to provide universally operable tools such as solid carbide drills applicable in any machining operation including drilling in various steel grades.

The invention

The present invention relates to a coated cutting tool comprising a substrate and a coating comprising a first, a second and a third layer, wherein

    i) the first layer is a (Ti, Al)N layer adhered to the substrate, said first layer having

        a. an atomic ratio Al/(Ti+Al) of 0.3 to 0.65, preferably from 0.4 to 0.65, more preferably from 0.5 to 0.65

        b. a fracture toughness ranging from 3.5 to 6 MPa $\sqrt{\text{m}}$, preferably from 4 to 5 MPa $\sqrt{\text{m}}$

        c. a substantially homogeneous residual stress $\sigma_1$ in the range from +100 to -1000 MPa, preferably from -300 to -700 MPa

    ii) the second layer is a (Ti, Al)N layer adhered to the first layer having

        a. an atomic ratio Al/(Ti+Al) of 0.3 to 0.85, preferably from 0.4 to 0.85
        b. a residual stress $\sigma_2$ ranging from about $\sigma_1$ at the interface with the first layer to $\sigma_3$ at the interface with the third layer, wherein $\sigma_2$ gradually increases from the interface with the first layer towards the interface with the third layer adhered to the second layer, wherein the residual stress $\sigma_2$ at the interface with the third layer is substantially the same as the residual stress in the third layer

    iii) the third layer is composed of a nitride of one or more elements belonging to group 4, 5 or 6 of the periodic table of elements, or a nitride of Al and/or Si together with one or more elements belonging to group 4, 5 or 6 of the periodic table of elements, said third layer having a substantially homogenous residual stress $\sigma_3$ < -1200 MPa, preferably $\sigma_3$ <-1400 MPa, more preferably -5000 MPa <$\sigma_3$ < -1500 MPa.

According to one embodiment, by substantially homogeneous residual stress is meant a maximum variation of 15 % or preferably a maximum variation of 5 % from an average value of the residual stress.

By the term "gradually" is also meant to include the increase may be stepwise and not necessarily continuously increasing. However, by "gradual" is preferably meant a continuous and regular increase, such as a continuous linear increase.

According to one embodiment, the second layer is a cubic (Ti, Al)N layer.

According to one embodiment, the third layer, which can be a single layer or a multilayer, is composed of a nitride containing at least one of Al, Zr, Ti, Nb and Cr, or a nitride of Al and/or Si together with at least one of Zr, Ti, Nb, and Cr. The third layer may suitably be composed of (Ti,Al)N, (Cr,Al)N, (Ti,Si)N, CrN, TiN, or NbN.

According to one embodiment, the third layer is a cubic (Ti, Al)N layer or a (Ti, Si)N layer having an atomic ratio Al/(Ti+Al) of 0.67 to 0.85 or an atomic ratio Si/(Ti+Si) of 0.05 to 0.2.

According to one embodiment, the atomic ratio Al/(Ti+Al) of the second layer gradually increases from the interface with the first layer to the interface with the third layer, for example from 0.5 to 0.8 or from 0.55 to 0.75.

The gradual increase in Al content in the second layer can be achieved in several ways. For example, an increase of the Al content can be achieved by the selection of the types and number of targets containing certain amounts of Al and Ti during the progress of the deposition process. Further, the Al and Ti contents in the deposited coating layers can be varied by varying the deposition condition, such as bias voltage and arc current.

According to one embodiment, at least one of the first, second and third layers is a multilayer composed of two or more alternating (Ti, Al)N sub-layer types different in their composition with an overall atomic ratio as specified herein.

According to one embodiment, at least one of the first, second, and third (Ti,Al)N layer is a multilayer of two or more alternating (Ti,Al)N sub-layer types different in their composition of which at least one (Ti,Al)N sub-layer type has an atomic ratio Al/(Ti+Al) of 0.50-0.67, preferably 0.55-0.67, most preferably 0.60-0.67, and at least one (Ti,Al)N sub-layer type has an atomic ratio Al/(Ti+Al) of 0.70-0.90, preferably 0.75-0.85.

The (Ti,Al)N sub-layer type in a multilayer suitably is a nanolayer which may have an average thickness of 1-100 nm, preferably 1.5-50 nm, most preferably 2-20 nm.

According to one embodiment, the first, second and third layers are single layers.

According to one embodiment, the third layer is a (Ti, Al)N layer having an atomic ratio Al/(Ti+Al) ranging from 0.70 to 0.85.

According to one embodiment, the atomic ratio Al/(Al+Ti) of the second layer is 0.7 to 0.85.

According to one embodiment, the mean grain size of the first layer ranges from 50 to 500 nm, preferably from 50 to 200 nm, and most preferably from 70 to 150 nm.

According to one embodiment, the thickness of the first layer ranges from 1 $\mu$m to 20 $\mu$m, for example from 2 $\mu$m to 10 $\mu$m such as from 3 $\mu$m to 8 $\mu$m.

According to one embodiment, the coating has a thickness of 3-25 $\mu$m, preferably 5-15 $\mu$m, most preferably 7-12 $\mu$m.

According to one embodiment, the first layer shows a distribution of 311 misorientation angles. A 311 misorientation angle is an angle between a normal vector to the surface of the first layer and the <311> direction that is closest to the normal vector to the surface of the first layer. Preferably, a cumulative frequency distribution of the 311 misorientation angles is such that $\geq$ 40% are less than 12.5°.

By the term 311 misorientation angle is meant the smallest angle, i.e., the angle between a normal vector to the (Ti,Al)N layer and the <311> direction that is closest to the normal vector to the (Ti,Al)N layer.

According to one embodiment, the cumulative frequency distribution of the 311 misorientation angles is such that more than 50%, such as more than 55 % are less than 12.5°.

According to one embodiment, the cumulative frequency distribution of the 311 misorientation angles is such that $\leq$ than 95%, such as less than 85% or less than 75% are less than 12.5°.

According to one embodiment, the cumulative frequency distribution of the 311 misorientation angles is such that 40 to 85%, for example from 50 to 75% are less than 12.5°.

According to one embodiment, the cumulative frequency distribution of the 311 misorientation angles is such that 5 to 40%, for example 8 to 25% or for example from 10 to 15%, are less than 5°.

The distribution of 311 misorientation angles can be determined in an electron backscatter analysis (EBSD). However, the columnar grain width is generally increasing by increasing the thickness of the (Ti,Al)N layer, especially for the first micrometers of the (Ti,Al)N layer and EBSD analysis may not be suitable if the grain width is too small. Therefore, in the case of a (Ti,Al)N layer of a thickness of 2 $\mu$m or less, the distribution of 311 misorientation angles is preferably determined in an transmission electron microscope (TEM) analysis, if the grain size is regarded to be too small for EBSD analysis. The EBSD or TEM analysis is suitably made within a distance of 0.7 mm from the cutting edge.

According to one embodiment, the third layer is the outermost layer.

According to one embodiment, the first layer (Ti,Al)N has a Vickers hardness of $\geq$ 2400 HV (15 mN load), preferably 2500 to 2800 HV (15 mN load).

According to one embodiment, the first layer (Ti,Al)N has a plane strain modulus of $\geq$ 450 GPa, preferably $\geq$ 500 GPa, for example from 450 to 550 or from 450 to 500 GPa. The third (Ti,Al)N layer has preferably a plane strain modulus of 450 to 530 GPa, more preferably 480 to 510 GPa.

The substrate of the coated cutting tool can be of any kind common in the field of cutting tools for metal machining. The substrate is suitably selected from cemented carbide, cermet, cubic boron nitride (cBN), ceramics, polycrystalline diamond (PCD) and high speed steel (HSS). In one preferred embodiment, the substrate is cemented carbide.

The coated cutting tool of the invention obtained by the process as further described herein has a low residual stress first layer. This is obtained by depositing the first layer on the substrate at the selected process conditions including a high temperature. The process also imparts increased fracture toughness to the first layer. The process also involves deposition of a second layer which is deposited while the temperature is linearly ramped down as further explained in the working example. This also results in a residual stress gradient across the second layer. The third layer is deposited at the lowest temperature used for the second layer whereby a single phase cubic structure of a (Ti, Al)N composition with high aluminium content can be deposited as an outermost layer. To improve the surface roughness and lower the surface adhesion of workpiece material, wet blasting and drag finishing can be performed. The coated cutting tool manufactured is preferably an insert for drilling such as a solid carbide drill, an insert for turning or end mill, or other indexable insert.

Brief descriptions of the drawings

Figure 1 shows a schematic view of one embodiment of a cutting tool being a milling insert.

Figure 2 shows a schematic view of the coated cutting tool and the temperature used during the deposition of the three layers.

Detailed description of embodiments in drawings

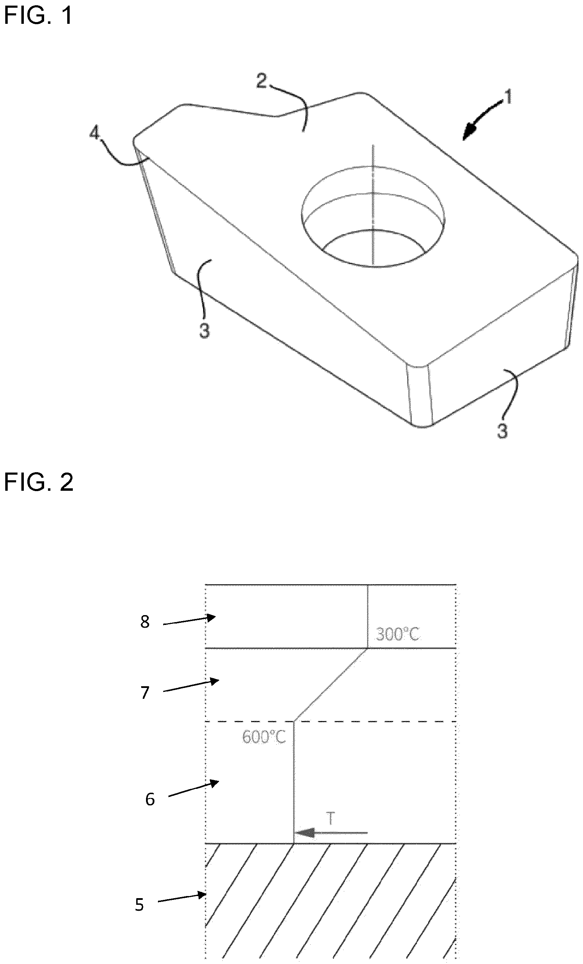

Figure 1 shows a schematic view of one embodiment of a cutting tool (1) having a rake face (2), a flank face (3) and a cutting edge (4). The cutting tool (1) is in this embodiment a milling insert. Figure 2 shows a schematic view of a cross section of an embodiment of the coated cutting tool of the present invention having a substrate body (5) and first (6), second (7) and third (8) coating layers.

Methods

Electron back scattering diffraction (EBSD):

A cumulative frequency distribution of 311 misorientation angles was calculated as follows: For each spot measurement of the total EBSD scan (representing an incremental surface area of the overall analyzed surface region) the crystallographic direction perpendicular to the surface plane of the (Ti,Al)N layer, is derived from the absolute crystallographic orientation measured (i.e. the orientation data in Euler angles).
Subsequently, the vector angle between this crystallographic direction and the closest <311>-type direction is calculated. Where "closest" refers to the <311>-type direction (among all twelve crystallographically equivalent possibilities) that includes the smallest possible angle with the surface normal. This angle is defined as the 311 misorientation angle. As each measurement point constitutes an equal fraction of the analyzed area, the relative frequency distribution of these angular misorientation values characterizes the overall degree of the 311 surface texture.

Electron diffraction in transmission electron microscopy (TEM):

The sample is suitably analysed in cross-section, i.e., the incident electron beam is parallel to the film plane. To rule out an amorphisation during sample preparation different methods can be used, i) classical preparation including mechanical cutting, gluing, grinding and ion polishing and ii) using a FIB to cut the sample and make a lift out to make the final polishing. The position of the analysis is, for example, near the substrate, about 200 nm from the substrate.
SAED data are then obtained for the sample. From the SAED data a diffraction intensity profile is provided along the 311 ring that is centered around the angular position that corresponds to the coating normal. Then normalized integrations are made both at the 311 diffraction spot and the -3-1-1 diffraction spot, respectively, going to 45 degrees misorientation angle. The two integrations are then combined into one intensity distribution curve. The intensity distribution data from both the 311 diffraction spot and the -3-1-1 diffraction spot are used in order to increase the number of data points thereby reducing the signal to noise ratio as much as possible.
The intensity at a certain misorientation angle is directly proportional to the sample volume that exhibits this misorientation. Thus, the intensity distribution curve is equivalent to the distribution of the 311 misorientation angles. Then, correspondingly, a cumulative intensity curve obtained from the intensity distribution curve is equivalent to a cumulative frequency distribution of the 311 misorientation angles.

Vickers hardness:

The Vickers hardness was measured by means of nanoindentation (load-depth graph) using a Picodentor HM500 of Helmut Fischer GmbH, Sindelfingen, Germany. For the measurement and calculation the Oliver and Pharr evaluation algorithm was applied, wherein a diamond test body according to Vickers was pressed into the layer and the force-path curve was recorded during the measurement. The maximum load used was 15 mN (HV 0.0015) and the time period for load increase and load decrease was 20 seconds each. From this curve, the hardness was calculated.

Plane strain modulus:

The elastic properties of the coating samples were characterized by the so-called plane strain modulus $E_{ps}$ as derived by nanoindentation via the Oliver and Pharr method. The nanoindentation data was obtained from indentation as described for Vickers hardness above.

Grain size:

The mean grain size is determined from SEM images by means of the stereological line intersection method: A line grid is overlaid to the micrograph of interest and the intersections of the lines with the grain boundary network are marked. The statistics of the distances between adjacent intersections reflect the size of the three-dimensional grains (e.g. H.E. Exner, Quantitative Description of Microstructures by Image Analysis, in: Mater. Sci. Technol., Wiley-VCH Verlag GmbH & Co. KGaA, Weinheim, Germany, 2006 (including section 15.3.5 "Size and spacing" - https://doi.org/10.1002/9783527603978.mst0024).

To account for the morphological peculiarities of PVD hard coatings (mostly elongated columnar shape of grains), the spacings between grain boundaries were only evaluated on lines that lie parallel to the film plane. Consequently, the data reflects the grain width parallel to the coating plane.

The respective SEM micrographs are taken from the flank face of three-fold rotated test inserts made of cemented carbide (substrate surface repeatedly facing the arc sources during deposition). They stem from a distance of 100 $\mu$m from the substrate edge. The grain width was determined at a defined coating height of 2 $\mu$m. A minimum of 380 spacing measurements were collected.

Residual stress:

The residual stress measurements were done according to the $\sin^2\psi$-method on a diffractometer from Seifert / GE (PTS 3003). CuKa-radiation with a polycapillary lens (for producing a parallel beam) was applied for the analysis (high tension 40 kV, current 40 mA). The incident beam was defined by a 2,0 mm pinhole. For the diffracted beam path an energy dispersive detector (Meteor 0D) was applied. An Eulerian cradle was used to tilt the specimen by the angle $\psi$ ($\psi$ = angle between specimen surface normal and diffraction vector). The {111}-cubic-TiAlN reflection was used to measure the residual stress in the sample. 15 $\psi$ angles in the interval -60° < $\psi$ < 60° (equidistant in $\sin^2 \psi$) were taken into account to determine the residual stress value in the coating. Assuming a rotational symmetric distribution of residual stress, only one $\varphi$-direction was used. For the stress evaluation in TiAlN the X-ray elastic constants $-s_1$ = 0,491 TPa$^{-1}$ and $0,5s_2$ = 2,780 TPa$^{-1}$ were applied. The Peakfitting was done by applying Rachinger correction (to correct for K$\alpha_2$) and a pseudo Voigt function to perform peak fitting.

For measurements of residual stress of a layer of a coating having further deposited layers above itself, coating material is removed above the layer to be measured. Care has to be taken to select and apply a method for the removal of material which does not significantly alter the residual stress within the remaining nitride multilayer material. A suitable method for the removal of deposited coating material may be polishing, however, gentle and slow polishing using a fine-grained polishing agent should be applied. Strong polishing using a coarse grained polishing agent will rather increase the residual stress, as it is known in the art. Other suitable methods for the removal of deposited coating material are ion etching and laser ablation.

Thickness:

The thickness of a layer was determined by calotte grinding using a steel ball having a diameter of 30 mm for grinding the dome shaped recess and further the ring diameters were measured, and the layer thicknesses were calculated therefrom. Measurements of the layer thickness on the rake face (RF) of the cutting tool were carried out at a distance of 2000 $\mu$m from the corner, and measurements on the flank face (FF) were carried out in the middle of the flank face.

Fracture toughness:

To quantify the fracture toughness of the investigated coatings, the micro-pillar splitting technique as developed by Sebastiani et al. [1, 2 and 4] was applied. In this testing method, a sharp indenter tip is centered on the top face of a micron-scale pillar of the sample material. With the pillar subjected to the load of the indenter, the force is continuously increased until failure - i.e. splitting - of the pillar occurs. The critical stress intensity factor for cracks to emanate from the indenter contact, i.e. the splitting fracture toughness $Kc$ can then be derived from the critical splitting force Pc via the following equation:

$$K_c = \gamma \, (E/H) \, P_c/R^{3/2} \, , \qquad (1)$$

where $\gamma$ represents a coefficient of proportionality that is dependent on the elastic-plastic properties of the tested material (ratio of Young's modulus E and Hardness H), while R denotes the radius of the pillar. The above equation is based on the analytical model of a semi-elliptical surface crack and validated by cohesive zone finite element modeling (CZ-FEM) [2].

The pillars were micro-machined from the coatings of interest by means of focused ion beam (FIB) milling. A single-pass milling strategy that utilizes concentric ring patterns of continuously decreasing diameter was used to minimize taper of the pillars. Accordingly, the FIB probe currents were successively lowered from 15 nA (initial roughing) to a final polishing current of 300 pA. All of the tested pillars featured a diameter of 7 $\mu$m and an aspect ratio of -1.3 (height-to-diameter ratio, > 1 is required by the pillar splitting technique [2]). Prior to any FIB milling the sample surfaces to be structured were carefully polished using a colloidal silica suspension with a nominal grain size of 40 nm (Struers OPS 0.04 $\mu$m). This step served to remove any roughness present on the as deposited coating surface. No more than 100 nm of the top coating is removed by this procedure. After this surface preparation the micro-pillars were consistently placed at a distance of -120 $\mu$m from the cutting edges, near a "nose radius" of the carrying substrates. Loading of the pillars was performed in a Fischer Picodenter HM500 nanoindentation system (Helmut Fischer GmbH, Sindelfingen, Germany) using a three-sided, pyramidal cube corner diamond indenter (nominal surface angle of 35.26°). The experiment were performed in a load-controlled manner using a constant loading rate of 1 mN/s. For each coating and sample state a minimum of 12 tests were performed to account for the intrinsic scatter of the fracture experiments (20 tests in most cases). The accuracy of the sample stage and tip positioning was experimentally validated to be within 10% of the used pillar radius to not distort the measurement results [3]. To calculate the fracture toughness according to equation (1) the coating specific $\gamma$-coefficient was derived from data published by Ghidelli et al. in ref [4]. Measurements can be performed by preparing a cross-section of an already coated tool or by carefully removing the top layers via mechanical polishing or focused ion-beam machining.

[1] M. Sebastiani, K.E. Johanns, E.G. Herbert, F. Carassiti, G.M. Pharr, A novel Pillar indentation splitting test for measuring fracture toughness of thin ceramic coatings, Philos. Mag. 95 (2015) 1928-1944. https://doi.org/10.1080/14786435.2014.913110.

[2] M. Sebastiani, K.E. Johanns, E.G. Herbert, G.M. Pharr, Measurement of fracture toughness by nanoindentation methods: Recent advances and future challenges, Curr. Opin. Solid State Mater. Sci. 19 (2015) 324-333. https://doi.org/10.1016/j.cossms.2015.04.003.

[3] C.M. Lauener, L. Petho, M. Chen, Y. Xiao, J. Michler, J.M. Wheeler, Fracture of Silicon: Influence of rate, positioning accuracy, FIB machining, and elevated temperatures on toughness measured by pillar indentation splitting, Mater. Des. 142 (2018) 340-349. https://doi.org/10.1016/j.matdes.2018.01.015.

[4] M. Ghidelli, M. Sebastiani, K.E. Johanns, G.M. Pharr, Effects of indenter angle on micro-scale fracture toughness measurement by pillar splitting, J. Am. Ceram. Soc. 100 (2017) 5731-5738. https://doi.org/10.1111/jace.15093.

Example 1

A WC-Co substrate was pretreated by means of plasma etching (central beam etching) prior to deposition of the coating to remove about 1 $\mu$m to eliminate organic residues and mitigate surface damage and residual stress due to prior grinding of the substrate. The etching was performed at a temperature of 600 °C at the following further process conditions:

I: 140 A

$U_{bias}$: 170 V

$p_{Ar}$: 0.21 Pa

$t_{etch}$: 65 minutes

An arc-deposited (Ti, Al)N three-layered coating was prepared by depositing on a cemented carbide substrate a first base layer, a second intermediate layer and a third top layer in the mentioned order. The first and the second layers were prepared from a $Ti_{0.40}Al_{0.60}$ target deposited onto a WC-Co based substrate. The substrate had a composition of 6 wt% Co and balance WC. The deposition was made using cathodic arc deposition in a Balzers Innova Arc-PVD system (Oerlikon Balzers Coating AG, Balzers, Liechtenstein) with the following process parameters:

**First (base) layer of (Ti,Al)N:**

| | |
|---|---|
| Target material: | $Ti_{0.40}Al_{0.60}$ |
| Target size: | circular 150 mm |
| Arc current: | 4x 200 A |
| Pressure: | 5 Pa |
| Temperature: | 600 °C |
| Total pressure: | 5 Pa ($N_2$) |
| Argon pressure: | 0 Pa (0 sccm Ar) |
| Bias potential: | -40 V |
| Both 2-fold and 3-fold rotation | |
| Source configuration | APO, mag 14 |

A layer thickness of about 3.1 $\mu$m was deposited.

**Second (intermediate) layer of (Ti,Al)N:**

| | |
|---|---|
| Target material: | $Ti_{0.40}Al_{0.60}$ |
| Target size: | circular 150 mm |
| Arc current: | 2 x 200 A |
| Pressure: | 5 Pa ($N_2$) |
| Temperature: | 600 to 300°C |
| Total pressure: | 5 Pa ($N_2$ pressure) |
| Argon pressure: | 0 Pa (0 Ar sccm) |
| Bias potential: | -40 V |
| Source configuration | APO, mag 14 |

The temperature was linearly ramped down from 600 °C to 300 °C during the coating step. The second layer was grown to a thickness of 1.5 $\mu$m.

**Third (top) layer of (Ti,Al)N:**

| | |
|---|---|
| Target material: | $Ti_{0.27}Al_{0.73}$ |
| Target size: | circular 150 mm |
| Arc current: | 2 x 120 A |
| Temperature: | 300°C |
| Total pressure: | 2 Pa |
| Argon flow: | 300 sccm |

(continued)

| | |
|---|---|
| Bias potential: | -80 V |
| Source configuration | APO, mag 14 |

A layer thickness of 1.4 $\mu$m was deposited. A coating with a total thickness of 6 $\mu$m was thus prepared.

| | |
|---|---|
| Residual stress of first layer: | - 600 MPa |
| Fracture toughness of first layer: | 4.1 MPa $\sqrt{}$ m |
| Hardness of the first layer: | 2600 HV |
| Plane strain modulus of the first layer: | 520 GPa |

Electron backscatter diffraction (EBSD) analysis was made on the first (base) layer of (Ti,Al)N. A cumulative frequency distribution of 311 misorientation angles was calculated, as described in the "Methods" section. The first (base) layer of (Ti,Al)N shows a cumulative frequency distribution of the 311 misorientation angles such that about 62% of the 111 misorientation angles are less than 12.5 degrees, and about 13% of the 311 misorientation angles are less than 5 degrees.

The third (top) layer of (Ti,Al)N shows a 111-texture. It is estimated that a cumulative frequency distribution of 111 misorientation angles for the third (top) layer of (Ti,Al)N is such that a cumulative frequency distribution of the 111 misorientation angles is such that >50% of the 111 misorientation angles are less than 10 degrees.

Example 2 (comparative)

A base layer was prepared as a comparison according to the preparation of the first (base) layer of example 1 with the exception that it was prepared with a thickness of 5.9 $\mu$m to make the coating thickness comparable to the total thickness of the coating of example 1.

Example 3

Drilling tests were performed for various work piece materials according to the below in a DMG MORI DMU65 MonoBlock vertical 3-axis machine. In this example 3, steel was machined with coated cutting tools prepared with coatings prepared in accordance with the coatings of examples 1 and 2. The number of holes to critical flank wear is indicated for the tested tools in table 1 below:

| | |
|---|---|
| Workpiece material: | steel C45, 1.1191 (705 N/mm$^2$) |
| Cutting speed, $v_c$: | 200 m/min |
| Feed/revolution: | 0.28 mm/revolution |
| Drilling depth: | 30 mm |
| Hole type: | through hole |
| KSS: | emulsion, 7%; 40 bar |

Table 1

| | Number of holes to critical flank wear |
|---|---|
| Sample of example 1 (invention) | 3995 |
| Sample of example 2 (reference) | 3055 |

As can be noted from table 1, a three-layered tool with the coating according to example 1 (the invention) has extended tool life compared to the single-layered coating of example 2 (reference).

Example 4

In example 4, an analog test was performed with respect to 42CrMo4 steel.

| Workpiece material: | 42CrMo$_4$, (EN-JL1040; 215HB) |
| Cutting speed, V$_c$: | 105 m/min |
| Feed/revolution: | 0.2 mm/revolution |
| Drilling depth: | 30 mm |
| Hole type: | through hole |
| KSS: | emulsion, 6%; 40 bar |

Table 2

|  | Number of holes to critical flank wear |
| --- | --- |
| Example 1 | 1692 |
| Example 2 (comparative) | 744 |

In table 2, significantly higher wear resistance with respect to critical flank wear was shown for the invention compared to the same reference.

**Claims**

1. A coated cutting tool comprising a substrate and a coating comprising a first, a second and a third layer, wherein

    i) the first layer is a (Ti, Al)N layer adhered to the substrate, said first layer having

       a. an atomic ratio Al/(Ti+Al) of 0.3 to 0.65
       b. a fracture toughness ranging from 3.5 to 6 MPa $\sqrt{}$ m
       c. a substantially homogeneous residual stress $\sigma_1$ in the range from +100 to -1000 MPa

    ii) the second layer is a (Ti, Al)N layer adhered to the first layer having

       a. an atomic ratio Al/(Ti+Al) of 0.3 to 0.85
       b. a residual stress $\sigma_2$ ranging from about $\sigma_1$ at the interface with the first layer to $\sigma_3$ at the interface with the third layer, wherein $\sigma_2$ gradually increases from the interface with the first layer towards the interface with the third layer adhered to the second layer, wherein the residual stress $\sigma_2$ at the interface with the third layer is substantially the same as in the third layer

    iii) the third layer is composed of a nitride of one or more elements belonging to group 4, 5 or 6 of the periodic table of elements, or a nitride of Al and/or Si together with one or more elements belonging to group 4, 5 or 6 of the periodic table of elements, said third layer having a substantially homogenous residual stress $\sigma_3$ < -1200 MPa.

2. Coated cutting tool according to claim 1, wherein the third layer is a cubic (Ti, Al)N layer or a (Ti, Si)N layer having an atomic ratio Al/(Ti+Al) of 0.67-0.85 or an atomic ratio Si/(Ti+Si) of 0.05 to 0.2.

3. Coated cutting tool according to claim 1 or 2, wherein the fracture toughness of the first layer ranges from 4 to 5 MPa $\sqrt{}$ m.

4. Coated cutting tool according to any one of claims 1 to 3, wherein the atomic ratio Al/(Ti+Al) of the second layer gradually increases from the interface with the first layer to the interface with the third layer.

5. Coated cutting tool according to any one of claims 1 to 4, wherein at least one of the first, second and third layers is a multilayer composed of two or more alternating (Ti, Al)N sub-layer types different in their composition, wherein the overall atomic ratio is as specified in claim 1.

6. Coated cutting tool according to any one of claims 1 to 5, wherein a cumulative frequency distribution of the 311 misorientation angles of the first layer is such that $\geq 40\%$ are less than 12.5°.

7. Coated cutting tool according to any one of claims 1 to 6, wherein the first, second and third layers are single layers.

8. Coated cutting tool according to any one of claims 1 to 7, wherein the third layer is a (Ti, Al)N layer having an atomic ratio Al/(Ti+Al) ranging from 0.70 to 0.85.

9. Coated cutting tool according to any one of claims 1 to 8, wherein the residual stress of the first layer ranges from -300 to -700 MPa.

10. Coated cutting tool according to any one of claims 1 to 9, wherein the tool is a solid carbide drill, an end mill, or an indexable insert.

11. Coated cutting tool according to any one of claims 1 to 10, wherein the atomic ratio Al/(Al+Ti) of the second layer is 0.7 to 0.85.

12. Coated cutting tool according to any one of claims 1 to 11, wherein the mean grain size of the first layer ranges from 50 to 500 nm.

13. Coated cutting tool according to any one of claims 1 to 12, wherein the thickness of the first layer ranges from 1 to 20 $\mu$m.

14. Coated cutting tool according to any one of claims 1 to 13, wherein the thickness of the coating ranges from 3 to 25 $\mu$m.

## FIG. 1

## FIG. 2

Europäisches
Patentamt

European
Patent Office

Office européen
des brevets

# EUROPEAN SEARCH REPORT

Application Number

EP 22 17 0878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/255931 A1 (SCHIER VEIT [DE] ET AL) 13 August 2020 (2020-08-13) * claims 1-16 * | 1-14 | INV. C23C28/04 C23C28/00 C23C30/00 |
| A | EP 3 839 098 A1 (WALTER AG [DE]) 23 June 2021 (2021-06-23) * paragraph [0082]; claims 1-18 * | 1-14 | C23C14/02 C23C14/06 C23C14/32 |
| A | JP 2003 326403 A (MITSUBISHI MAT KOBE TOOLS CORP) 18 November 2003 (2003-11-18) * claim 1 * | 1-14 | |
| A | US 2020/173012 A1 (KUMAR VINEET [US] ET AL) 4 June 2020 (2020-06-04) * claims 1-23 * | 1-14 | |

|  |  |
|---|---|
|  | TECHNICAL FIELDS SEARCHED (IPC) |
|  | C23C |

The present search report has been drawn up for all claims

| Place of search | Date of completion of the search | Examiner |
|---|---|---|
| The Hague | 14 June 2022 | Chalaftris, Georgios |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 0878

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2022

| Patent document cited in search report | | Publication date | Patent family member(s) | | Publication date |
|---|---|---|---|---|---|
| US 2020255931 | A1 | 13-08-2020 | CN | 111032915 A | 17-04-2020 |
| | | | EP | 3676422 A1 | 08-07-2020 |
| | | | JP | 2020531300 A | 05-11-2020 |
| | | | KR | 20200045482 A | 04-05-2020 |
| | | | US | 2020255931 A1 | 13-08-2020 |
| | | | WO | 2019043167 A1 | 07-03-2019 |
| EP 3839098 | A1 | 23-06-2021 | EP | 3839098 A1 | 23-06-2021 |
| | | | WO | 2021122892 A1 | 24-06-2021 |
| JP 2003326403 | A | 18-11-2003 | NONE | | |
| US 2020173012 | A1 | 04-06-2020 | CN | 108977808 A | 11-12-2018 |
| | | | DE | 102018110200 A1 | 06-12-2018 |
| | | | US | 2018347027 A1 | 06-12-2018 |
| | | | US | 2020173012 A1 | 04-06-2020 |

EPO FORM P0459

For more details about this annex : see Official Journal of the European Patent Office, No. 12/82

## REFERENCES CITED IN THE DESCRIPTION

**Non-patent literature cited in the description**

- Quantitative Description of Microstructures by Image Analysis. **H.E. EXNER.** Mater. Sci. Technol. Wiley-VCH Verlag GmbH & Co. KGaA, 2006
- **M. SEBASTIANI ; K.E. JOHANNS ; E.G. HERBERT ; F. CARASSITI ; G.M. PHARR.** A novel Pillar indentation splitting test for measuring fracture toughness of thin ceramic coatings. *Philos. Mag.,* 2015, vol. 95, 1928-1944, https://doi.org/10.1080/14786435.2014.913110
- **M. SEBASTIANI ; K.E. JOHANNS ; E.G. HERBERT ; G.M. PHARR.** Measurement of fracture toughness by nanoindentation methods: Recent advances and future challenges. *Curr. Opin. Solid State Mater. Sci.,* 2015, vol. 19, 324-333, https://doi.org/10.1016/j.cossms.2015.04.003
- **C.M. LAUENER ; L. PETHO ; M. CHEN ; Y. XIAO ; J. MICHLER ; J.M. WHEELER.** Fracture of Silicon: Influence of rate, positioning accuracy, FIB machining, and elevated temperatures on toughness measured by pillar indentation splitting. *Mater. Des.,* 2018, vol. 142, 340-349, https://doi.org/10.1016/j.matdes.2018.01.015
- **M. GHIDELLI ; M. SEBASTIANI ; K.E. JOHANNS ; G.M. PHARR.** Effects of indenter angle on micro-scale fracture toughness measurement by pillar splitting. *J. Am. Ceram. Soc.,* 2017, vol. 100, 5731-5738, https://doi.org/10.1111/jace.15093